# EUROPÄISCHE PATENTSCHRIFT

(11) **EP 1 393 449 B1**
(45) Veröffentlichungstag und Bekanntmachung des Hinweises auf die Patenterteilung: **24.01.2007**
(21) Anmeldenummer: 01956270.1
(22) Anmeldetag: 13.06.2001
(51) Int. Cl.: H03M 3/02

(54) **DIGITAL/ANALOG-WANDLER**
DIGITAL-ANALOG CONVERTER
CONVERTISSEUR ANALOGIQUE/NUMERIQUE

(30) Priorität: 28.06.2000 DE 10031538
(43) Veröffentlichungstag der Anmeldung: 03.03.2004
(73) Patentinhaber: SIEMENS AKTIENGESELLSCHAFT, 80333 München (DE)
(72) Erfinder: SPLETT, Armin, 89081 Ulm (DE); WOLFF, Gunter, 89081 Ulm (DE)
(86) Internationale Anmeldenummer: PCT/DE2001/002211
(87) Internationale Veröffentlichungsnummer: WO 2002/001724

(56) Entgegenhaltungen:
- EP-A- 0 577 887
- WO-A-95/01006
- US-A- 4 663 610

## Beschreibung

Die Erfindung betrifft einen Digital/Analog-Wandler gemäß Patentanspruch 1.

Derartige Digital/Analog-Wandler werden insbesondere in Mobilfunk-Basisstationen eingesetzt, um digitale Daten mit einer hohen Bitrate in hochfrequente Sendesignale umzusetzen. Hierbei sollen die hochfrequenten Sendesignale mit einer hohen spektralen Reinheit erzeugt werden, d. h. möglichst wenig störende Nebenfrequenzen aufweisen. Dies soll zudem mit möglichst geringem technischen Aufwand kostengünstig erreicht werden. Typischerweise sollen die hochfrequenten Sendesignale einen oder mehrere modulierte Frequenzträger aufweisen und eine große Bandbreite abdecken können.

Bisher wurden hierfür Architekturen eingesetzt, die mittels herkömmlicher Digital/Analog-Wandler breitbandige analoge Signale in einem für das Senden zu niedrigen Frequenzbereich erzeugen. Anschließend werden dann die analogen Signale mittels einer oder zwei Frequenzumsetzerstufen, beispielsweise Mischer-Stufen, in die hochfrequenten Sendesignale umgesetzt, um von der Mobilfunkbasisstation per Funk gesendet zu werden.

Die Mischer-Stufen erfordern allerdings einen hohen schaltungstechnischen Aufwand, insbesondere einen hohen Aufwand an elektronischen Bauelementen. Im allgemeinen sind die Mischer-Stufen nicht als integrierte Schaltungen ausführbar, da Filter mit einer hohen Güte eingesetzt werden müssen, die bekanntermaßen eine Vielzahl passiver Bauelemente wie Kondensatoren und Widerstände benötigen. Passive Bauelemente sind jedoch ungünstig in integrierten Schaltungen auszuführen, insbesondere wenn für Filter hoher Güte genaue und teilweise große Kapazitäts- und/oder Induktivitätswerte erforderlich sind. Ferner müsse alle Zwischenfrequenzen getrennt abgeschirmt werden. Für eine kostengünstige und daher wirtschaftliche Lösung wäre daher ein Digital/Analog-Wandler erforderlich, der eine geringe Anzahl an elektronischen, insbesondere passiven Bauelementen umfaßt und sich vorzugsweise für eine Ausführung als integrierte Schaltung eignet.

Aus US 4,663,610 ist ein Digital-Analog-Wandler bekannt, der zwei parallel geschaltete D-Flip-Flop, eine Einrichtung zur Clock-Signal-Teilung sowie eine Anzahl an Transistoren und Stromquellen aufweist. Dabei wird das Schaltverhalten einzelner Schalter bezüglich der Schaltzeit minimiert, um eine Datenrate zu optimieren.

Der Erfindung liegt daher die Aufgabe zugrunde, einen Digital/Analog-Wandler zu schaffen, der eine einfache Struktur besitzt, insbesondere Filter hoher Güte vermeidet und sich daher vorzugsweise als integrierte Schaltung ausführen läßt. Ferner soll der erfindungsgemäße Digital/Analog-Wandler ein analoges Ausgangssignal erzeugen, das als hochfrequentes Sendesignal verwendbar ist.

Diese Aufgabe wird durch einen Digital/Analog-Wandler mit den Merkmalen von Patentanspruch 1 gelöst. Vorteilhafte Ausgestaltungen des erfindungsgemäßen Digital/Analog-Wandlers sind Gegenstand der abhängigen Ansprüche.

Der erfindungsgemäße Digital/Analog-Wandlers umfaßt zwei Grundstrukturen, nämlich ein D-Flip-Flop und einen Modulator, der dem D-Flip-Flop nachgeschaltet ist. Das D-Flip-Flop wird mit einem Taktsignal getaktet und dem Eingang des D-Flip-Flops wird ein digitales Eingangssignal zugeführt, das in ein analoges Ausgangssignal umgesetzt werden soll.

Ziel der Erfindung ist es, ein analoges Ausgangssignal in einem Frequenzbereich zu erzeugen, der zum Senden geeignet ist. Das analoge Ausgangssignal muß also im Frequenzbereich hochfrequenter Sendesignale liegen. Hierzu wird das Ausgangssignal des D-Flip-Flops vom Modulator mit dem Taktsignal multipliziert. Im Modulator wird das Taktsignal so verzerrt, daß die Nulldurchgänge des Taktsignals zeitlich verlängert werden. Hierdurch wird im Ausgangssignal des D-Flip-Flops enthaltener Jitter im Modulator während der Nulldurchgänge des verzerrten Taktsignals wirkungsvoll unterdrückt.

Die spektrale Reinheit des analogen Ausgangssignals des Modulators wird im wesentlichen durch die spektrale Reinheit des Taktsignals bestimmt. Dabei sind keine Taktsignale mit unterschiedlichen Phasen für das D-Flip-Flop und den Modulator nötig, wie bei bisherigen Lösungsansätzen nach dem Stand der Technik. Aus diesem Grunde wird auch ein 90-Grad-Phasenschieber eingespart. Zudem ist die Frequenz niedriger als bei bekannten Digital/Analog-Wandlern, deren Ausgangssignale direkt im Hochfrequenzbereich liegen. Dies resultiert aus der Tatsache, daß der Modulator zusätzlich die Frequenz des Ausgangssignals des D-Flip-Flops derart umsetzt, daß sich alle Oberwellen konstruktiv überlagern und kein unnötiges Quantisierungsrauschen hinzugefügt wird.

Vorzugsweise ist das Taktsignal ein spektral hochreines, sinusförmiges Signal. Hierdurch wird ein analoges Ausgangssignal am Modulator mit einer besonders hohen spektralen Reinheit erzeugt, d. h. im wesentlichen ohne störende Nebenfrequenzen.

Für die Frequenz des digitalen Eingangssignals und die Frequenz des Taktsignales haben sich die folgenden Werte als besonders vorteilhaft erwiesen: Das digitale Eingangssignal soll ein Frequenzband bei einem Viertel der Taktfrequenz belegen. In dem analogen Ausgangsspektrum wiederum erweist sich das Frequenzband bei fünf Vierteln der Taktfrequenz als besonders günstig.

Allgemein erweist es sich als günstig, wenn das Frequenzband des digitalen Eingangssignals bei einem Viertel der Taktfrequenz liegt und das analoge Ausgangssignal bei (2n+1) Vierteln der Taktfrequenz liegt. Hierbei ist es besonders günstig, wenn die Bedingung n = 4k+1 oder n = 4k+2 mit k=0,1,2,... erfüllt ist.

Vorzugsweise wird n = 2 gewählt, da sich für diesen Fall die bereits erwähnte vorteilhafte Beziehung ergibt, nämlich daß die Frequenz des digitalen Eingangssignals bei einem Viertel der Taktfrequenz und das analoge Ausgangssignal bei fünf Vierteln der Taktfrequenz liegen.

Für die üblicherweise zu erzeugenden sehr hohe Frequenz des analogen Ausgangssignals sowie die hohe Frequenz des digitalen Eingangssignals eignet sich vorzugsweise eine Ausführung des D-Flip-Flops und des Modulators in Bipolartechnologie. Denkbar ist auch eine Ausführung in einer schnellen MOS-Technologie. Die beiden vorgenannten Technologien sind bekanntermaßen für die Integration der Schaltung in Siliziumtechnologie oder auch GaAs-Technologie besonders geeignet.

Besonders vorteilhaft kann der Digital/Analog-Wandler betrieben werden, wenn das digitale Eingangssignal 13 rauschgeformt ist, wobei das Quantisierungsrauschen des Digitalsignals in Frequenzbereiche verschoben wird, die keine Signalanteile enthalten. Dies kann beispielsweise durch einen vorgeschalteten Sigma/Delta-Modulator erfolgen.

Für einen mehrstufigen Aufbau eignet sich der Digital/Analog-Wandler ebenso vorteilhaft; hierzu werden einfach mehrere der erfindungsgemäßen Digital/Analog-Wandler in der Form parallel geschaltet, daß den Eingängen der D-Flip-Flops der Digital/Analog-Wandler jeweils verschiedene digitale Eingangssignale zugeführt werden und die entsprechenden analogen Ausgangssignale an den Ausgängen der Modulatoren einfach addiert werden. Diese Ausführungsform läßt sich zudem vorteilhaft als integrierte Schaltung ausführen.

Weitere Vorteile und Anwendungsmöglichkeiten des erfindungsgemäßen Digital/Analog-Wandlers ergeben sich aus der nachfolgenden Beschreibung eines Ausführungsbeispiels in Verbindung mit den Zeichnungen. In den Zeichnungen zeigt:
Figur 1 ein Ausführungsbeispiel des erfindungsgemäßen Digital/Analog-Wandlers in Bipolartechnologie;
Figur 2 den charakteristischen Teil des Frequenzspektrums am Ausgang des in dem in Figur 1 dargestellten Digital/Analog-Wandler eingesetzten D-Flip-Flops; und
Figur 3 das prinzipielle Frequenzspektrum des analogen Ausgangssignals des in Figur 1 dargestellten Digital/Analog-Wandlers.

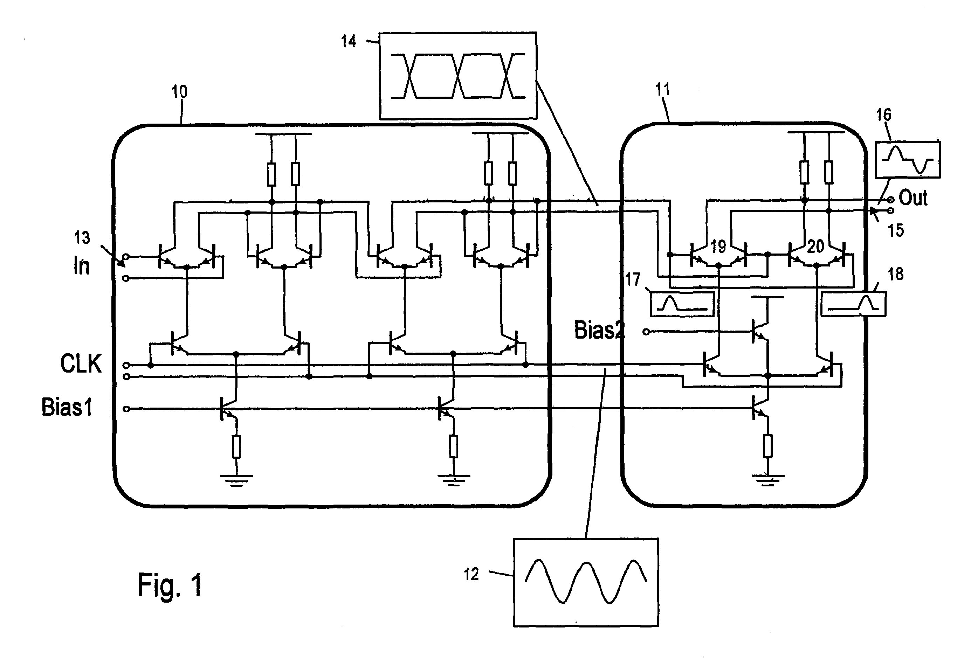

In Figur 1 ist mit 10 ein D-Flip-Flop in Bipolartechnologie bezeichnet, das jeweils einen differentiellen Eingang "In" für ein digitales Eingangssignal 13 aufweist, das in ein analoges Ausgangssignal umgesetzt werden soll, welches in einem Frequenzbereich liegt, der sich insbesondere zum Übertragen des Ausgangssignals über einen Mobilfunkkanal eignet. Ferner wird über einen mit "Bias1" bezeichneten Eingang die Stromaufnahme des D-Flip-Flops 10 eingestellt.

Schließlich weist das D-Flip-Flop 10 einen weiteren differentiellen Eingang "CLK" für ein Taktsignal 12 auf. Das Taktsignal 12 entspricht - wie in Figur 1 dargestellt - einem spektral hochreinen, sinusförmigen Signal mit einer Frequenz von vier Fünfteln einer Vorgabefrequenz, bei der die Frequenz f_{Out} des zu erzeugenden analogen Ausgangssignals liegt. Je frequenzstabiler das Taktsignal 12 ist, d. h. je weniger Phasenrauschen es aufweist, desto reiner ist auch das Frequenzspektrum des zu erzeugenden analogen Ausgangssignal. Idealerweise ist das Taktsignal ein sinusförmiges Signal mit hoher spektraler Reinheit, d.h. im wesentlichen frei von störenden Nebenfrequenzen.

Dem D-Flip-Flop 10 ist ein Modulator 11, der ebenfalls in Bipolartechnologie ausgeführt ist, nachgeschaltet. Der Modulator 11 ist wie das D-Flip-Flop 10 über den mit "Bias1" bezeichneten Eingang in seiner Stromaufnahme einstellbar. Darüber hinaus erfolgt über einen mit "Bias2" bezeichneten Eingang die Einstellung des Schwellwertes für die Pulsverzerrung. Im Prinzip entspricht der Modulator 11 einer Multipliziererschaltung, die das Ausgangssignal 14 des D-Flip-Flops 10, dessen idealisiertes Augendiagramm schematisch dargestellt ist, mit dem Taktsignal 12 multipliziert. Allerdings wird vor der Multiplikation der beiden Signale das Taktsignal 12 in dem Modulator 11 derart verzerrt, daß die Nulldurchgänge des Taktsignals, genauer gesagt die Nulldurchgänge des sinusförmigen Taktsignals zeitlich verlängert werden, wie es anhand der beiden kleinen Signalverlaufsdiagramme 17 und 18 schematisch dargestellt ist. Durch diese Verzerrung des Taktsignals wird im wesentlichen ein gegebenenfalls im Ausgangssignal 14 des D-Flip-Flops 10 enthaltener Jitter wirkungsvoll unterdrückt.

Nach der Verzerrung des Taktsignals 12 im Modulator 11 wird die Multiplikation mit dem Ausgangssignal 14 des D-Flip-Flops 10 mittels zweier parallel geschalteter differentieller Umschaltstufen 19 und 20 durchgeführt. An den Kollektoren der Transistoren der beiden differentiellen Umschaltstufen 19 und 20 liegt ein analoges Ausgangssignal 16 - wie schematisch dargestellt - an einem Ausgang 15 des Modulators 11 an. Das analoge Ausgangssignal 16 liegt hierbei in einem Frequenzbereich, der dem Sendefrequenzbereich, d. h. dem Frequenzbereich zur Übertragung von Funksignalen in einer Mobilfunkbasisstation entspricht. Eine weitere Umsetzung des analogen Ausgangssignals in einen anderen Frequenzbereich ist daher nicht mehr erforderlich. Entsprechende Mischer-Stufen können eingespart werden.

Anhand von Figur 1 ist der hochsymmetrische Aufbau sowohl des D-Flip-Flops 10 als auch des Modulators 11 erkennbar, wodurch kaum unerwünschte Phasenverschiebungen der zu verarbeitenden Signale auftreten. Insbesondere bei einer Ausführung als integrierte Schaltung kann eine hohe Symmetrie des D-Flip-Flops 10 und des Modulators 11 erzielt werden, da bekanntermaßen die Eigenschaften von Transistoren im Verhältnis zueinander sehr genau bei einer Integration einstellbar sind.

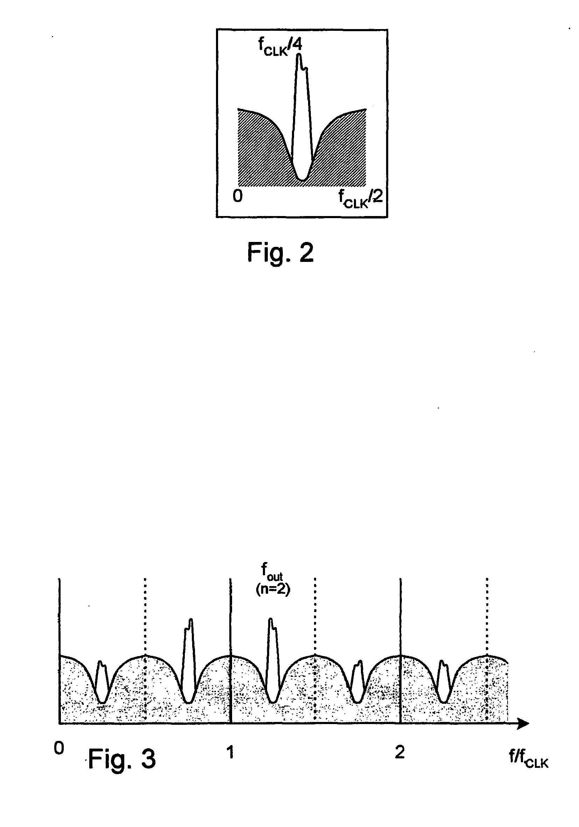

Figur 2 zeigt den charakteristischen Teil des Frequenzspektrums des D-Flip-Flops 10. Bei einem Viertel der Taktfrequenz liegt im Frequenzspektrum das digitale Eingangssignal 13 des D-Flip-Flops, das von geformtem Quantisierungsrauschen (schraffiert dargestellt) umgeben ist. Das Ausgangssignal 14 des D-Flip-Flops 10 wird durch den Modulator 11 in verschiedene Frequenzbereiche bei (2n+1) Vierteln der Taktfrequenz umgesetzt.

Das prinzipielle Frequenzspektrum des Ausgangssignals am Ausgang 15 des Modulators 11 ist in Figur 3 dargestellt. Je nach Form der Einzelpulse 17, 18 im Modulator erscheint das analoge Ausgangssignal unterschiedlich stark in den einzelnen Frequenzbereichen, die bei (2n+1) Viertel der Taktfrequenz liegen. Zwischen den einzelnen Peaks in den Frequenzbereichen, wo das analoge Ausgangssignal liegt, befinden sich Bereiche. die kein Signal enthalten. In diesen Bereichen liegt das geformte Quantisierungsrauschen, was schraffiert dargestellt ist. Dieses kann zusammen mit den unerwünschten Signalbändern durch eine entsprechende Filterung, beispielsweise in einer schmalbandigen Sendestufe, entfernt werden.

Als besonders günstig hat es sich erwiesen, wenn die Frequenz des digitalen Eingangssignals bei einem Viertel der Taktfrequenz liegt und das analoge Ausgangssignal das Frequenzband bei fünf Vierteln der Taktfrequenz belegt.

Allgemein gilt, daß Frequenzwerte bei einem Viertel der Taktfrequenz günstig für das digitale Eingangssignal sind und sich somit Ausgangssignale bei (2n+1) Vierteln der Taktfrequenz (vorteilhaft für n = 4k+1 oder n = 4k+2) ergeben.

## Patentansprüche

1. Digital/Analog-Wandler, insbesondere für Mobilfunk-Basisstationen,
- mit einem D-Flip-Flop (10) und mit einem Modulator (11),
- bei dem das D-Flip-Flop (10) und der Modulator (11) jeweils einen Eingang (CLK) aufweisen, an den ein Taktsignal (12) angeschaltet ist,
- bei dem das D-Flip-Flop (10) einen Eingang (In) aufweist, an den ein digitales Eingangssignal (13) angeschaltet ist,
- bei dem das D-Flip-Flop über einen Ausgang mit einem Eingang des Modulators (11) verbunden ist, so dass ein Ausgangssignal (14) des D-Flip-Flop (10) als Eingangssignal (14) an den Modulator (11) gelangt,
**dadurch gekennzeichnet,**
- **dass** der Modulator Mittel beinhaltet, durch die Taktsignal-Nulldurchgänge (17, 18) des an den Modulator (11) angeschalteten Taktsignals (12) zeitlich verlängert werden, wodurch ein verzerrtes Taktsignal gebildet wird, und
- **dass** der Modulator (11) zur Multiplikation des Modulator-Eingangssignals (14) mit dem verzerrten Taktsignal ausgestaltet ist, so dass durch die Multiplikation ein analoges Ausgangssignal (16) gebildet wird, das am Modulatorausgang (15) anliegt.

2. Digital/Analog-Wandler nach Anspruch 1, **dadurch gekennzeichnet, daß** das Taktsignal (12) ein spektral hochreines, frequenzstabiles Signal ist.

3. Digital/Analog-Wandler nach Anspruch 1 oder 2, **dadurch gekennzeichnet, daß** die Frequenz des digitalen Eingangssignals (13) bei einem Viertel und die Frequenz des Ausgangssignales (14) bei (2n+1) Vierteln der Frequenz des Taktsignals (12) liegen, wobei insbesondere n = 4k+1 oder n = 4k+2 mit k=0, 1, 2, ... gilt.

4. Digital/Analog-Wandler nach Anspruch 3, **dadurch gekennzeichnet, daß** n = 2 ist.

5. Digital/Analog-Wandler nach einem der vorhergehenden Ansprüche, **dadurch gekennzeichnet, daß** das D-Flip-Flop (10) und der Modulator (11) in Bipolartechnologie ausgeführt sind.

6. Digital/Analog-Wandler nach einem der vorhergehenden Ansprüche, **dadurch gekennzeichnet, daß** das Quantisierungsrauschen des Eingangssignals (13) durch einen Sigma/Delta-Modulator spektral geformt wird.

7. Mehrstufiger Digital/Analog-Wandler mit einem Digital/Analog-Wandler nach einem der vorhergehenden Ansprüche, wobei den Eingängen der D-Flip-Flops jeweils digitale Eingangssignale zugeführt werden und die analogen Ausgangssignale an den Ausgängen der Modulatoren addiert werden.

## Claims

1. Digital-analogue converter, in particular for mobile radiotelephone base stations,
- having a D flip-flop (10) and a modulator (11),
- whereby the D flip-flop (10) and the modulator (11) each comprise an input (CLK), to which a clock signal (12) is applied,
- whereby the D flip-flop (10) has an input, to which a digital input signal (13) is applied.
- whereby the D flip-flop is connected to an input of the modulator (11) by way of an output, so that an output signal (14) from the D flip-flop (10) reaches the modulator (11) as an input signal (14),
**characterised in that**
the modulator contains means, by means of which the clock signal zero points (17, 18) of the clock signal (12) connected to the modulator (11) is temporarily delayed, thereby forming a distorted clock signal,
- such that the modulator (11) for multiplying the modulator input signal (14) is configured with the distorted clock signal such that by means of the multiplication an analogue output signal (16) is formed which is present at the modulator output (15).

2. Digital-analogue converter according to claim 1, **characterised in that** the clock signal (12) is a frequency-stable signal of high spectral purity.

3. Digital-analogue converter according to claim 1 or 2, **characterised in that** the frequency of the digital input signal (13) lies at one quarter and the frequency of the output signal (14) lies at (2n+1) quarters of the frequency of the clock signal (12), whereby n = 4k+1 or n = 4k+2 where k=0, 1, 2, ... holds true in particular.

4. Digital-analogue converter according to claim 3, **characterised in that** n = 2.

5. Digital-analogue converter according to one of the preceding claims, **characterised in that** the D flip-flop (10) and the modulator (11) are implemented in bipolar technology.

6. Digital-analogue converter according to one of the preceding claims, **characterised in that** quantisation noise of the input signal (13) is shaped spectrally by means of a sigma-delta modulator.

7. Multistage digital-analogue converter with a digital-analogue converter according to one of the preceding claims, whereby digital input signals are fed to the inputs of the D flip-flops in each case and the analogue output signals are added at the outputs of the modulators.

## Revendications

1. Convertisseur numérique / analogique, en particulier pour des stations de base radio mobiles,
- avec une bascule D (10) et un modulateur (11),
- dans lequel la bascule D (10) et le modulateur (11) comportent respectivement une entrée (CLK) à laquelle est connecté un signal d'horloge (12),
- dans lequel la bascule D (10) comporte une entrée (In) à laquelle est connecté un signal numérique d'entrée (13),
- dans lequel la bascule D est reliée à une entrée du modulateur (11) via une sortie de sorte qu'un signal de sortie (14) de la bascule D (10) parvient au modulateur (11) en tant que signal d'entrée (14),
**caractérisé en ce que**
- le modulateur contient des moyens par lesquels les passages de signal d'horloge par zéro (17, 18) du signal d'horloge (12) connecté au modulateur (11) subissent un prolongement temporel, suite à quoi se forme un signal d'horloge distordu, et
- le modulateur (11) est aménagé pour multiplier le signal d'entrée du modulateur (14) par le signal d'horloge distordu de sorte que se forme, par la multiplication, un signal analogique de sortie (16) qui est appliqué à la sortie du modulateur (15).

2. Convertisseur numérique / analogique selon la revendication 1, **caractérisé en ce que** le signal d'horloge (12) est un signal stable en fréquence, de haute pureté spectrale.

3. Convertisseur numérique / analogique selon la revendication 1 ou 2, **caractérisé en ce que** la fréquence du signal numérique d'entrée (13) est à un quart et la fréquence du signal de sortie (14), à (2n+1) quarts de la fréquence du signal d'horloge (12), avec en particulier n = 4k+1 ou n = 4k+2 avec k = 0, 1, 2, ...

4. Convertisseur numérique / analogique selon la revendication 3, **caractérisé en ce que** n = 2.

5. Convertisseur numérique / analogique selon l'une des revendications précédentes, **caractérisé en ce que** la bascule D (10) et le modulateur (11) sont réalisés en technologie bipolaires.

6. Convertisseur numérique / analogique selon l'une des revendications précédentes, **caractérisé en ce que** le bruit de quantification du signal d'entrée (13) subit une mise en forme spectrale par un modulateur sigma-delta.

7. Convertisseur numérique / analogique multi-étagé avec un convertisseur numérique / analogique selon l'une des revendications précédentes, des signaux numériques d'entrée étant respectivement amenés aux entrées des bascules D et les signaux analogiques de sortie aux sorties des modulateurs étant additionnés.
